# DEMANDE DE BREVET EUROPEEN

(11) **EP 4 354 491 A1**
(43) Date de publication de la demande: **17.04.2024**
(21) Numéro de dépôt: 23203561.8
(22) Date de dépôt: 13.10.2023
(51) Int. Cl.: H01L 21/56, H01L 23/36, H01L 23/552, H01L 23/427, H01L 21/60, H01L 23/31, H01L 23/367, H01L 23/498, H01L 23/373

(54) **DISPOSITIF ELECTRONIQUE DE TYPE SIP ET PROCEDE DE REALISATION D'UN TEL DISPOSITIF**

(30) Priorité: 14.10.2022 FR 2210616
(71) Demandeur: Commissariat à l'Énergie Atomique et aux Énergies Alternatives, 75015 Paris (FR)
(72) Inventeur: COUDRAIN, Perceval, 38054 Grenoble cedex 09 (FR); GARNIER, Arnaud, 38054 Grenoble cedex 09 (FR); PIGNOL, Jeanne, 38054 Grenoble cedex 09 (FR)
(74) Mandataire: Brevalex

(57) **Abrégé**

Procédé de réalisation d'un dispositif électronique de type SiP, comprenant :
- report d'une puce électronique (100) sur un premier substrat (102) tel qu'une face d'interconnexion électrique de la puce soit disposée du côté du premier substrat ;
- encapsulation de la puce dans un matériau d'encapsulation (108) ;
- réalisation d'au moins une première couche métallique (112) sur le matériau d'encapsulation et la puce ;
- réalisation d'au moins une deuxième couche métallique (114) sur un deuxième substrat (116) ;
- collage des première et deuxième couches métalliques;
- désolidarisation du premier substrat (102) vis-à-vis de la puce et du matériau d'encapsulation ;
- réalisation d'au moins une couche de redistribution (121) couplée électriquement à la face d'interconnexion électrique ;
- réalisation d'éléments d'interconnexion électrique (122) sur la couche de redistribution tels que les éléments d'interconnexion électrique soient couplés électriquement à la puce par la couche de redistribution.

## Description

### DOMAINE TECHNIQUE

L'invention concerne le domaine du packaging, ou encapsulation, de puces électroniques pour la réalisation de dispositifs électroniques de type SiP (« System-in-Package » en anglais, ou système en boîtier), en particulier de type FOWLP (« Fan Out Wafer Level Packaging » en anglais).

### État de la technique antérieure

Le packaging FOWLP devient un standard, notamment pour l'intégration de puces électroniques de type SiP. Dans ce type de packaging, les plots d'interconnexion des puces, qui se trouvent du côté d'une face d'interconnexion de chaque puce, sont interconnectés, via une ou plusieurs couches de redistribution formées contre les faces d'interconnexion des puces, à des éléments d'interconnexion de plus grandes dimensions que les plots d'interconnexion des puces et répartis sur une plus grande surface que celle de la face d'interconnexion de chaque puce. Ces éléments d'interconnexion correspondent par exemple à des microbilles de matériau fusible. Les puces électroniques sont en outre encapsulées dans une résine d'encapsulation.

Un point critique dans ce type de packaging est la dissipation thermique qui doit être réalisée pour évacuer la chaleur produite par les puces électroniques. Les solutions existantes pour réaliser cette dissipation thermique font appel à des dissipateurs externes, actifs ou passifs, reportés sur le matériau d'encapsulation ou directement sur les puces, à la fin du procédé de packaging. Un matériau d'interface thermique, tel que de la colle ou de la graisse thermique, est disposé entre les dissipateurs et le matériau d'encapsulation, ou directement entre les dissipateurs et les puces, pour permettre leur assemblage et assurer le meilleur contact possible en comblant les irrégularités présentes entre les dissipateurs et les puces ou le matériau d'encapsulation. Ces solutions sont toutefois coûteuses du fait que les dissipateurs ne sont pas couplés aux puces de manière collective mais individuellement. De plus, les performances de dissipation thermique obtenues ne sont pas optimales du fait que le matériau d'interface thermique utilisé limite la conduction thermique entre les puces et les dissipateurs.

### EXPOSÉ DE L'INVENTION

Un but de la présente invention est de proposer un dispositif électronique de type SiP adapté à un packaging de type FOWLP, ne nécessitant pas l'utilisation d'un matériau d'interface thermique et améliorant les performances de dissipation thermique obtenues. Pour cela, il est proposé un dispositif électronique de type SiP, comprenant au moins :
- une puce électronique dotée d'une face d'interconnexion électrique ;
- une couche de redistribution couplée électriquement à la face d'interconnexion électrique de la puce électronique ;
- des éléments de connexion électrique couplés électriquement à la puce électronique par la couche de redistribution qui est disposée entre la puce électronique et les éléments de connexion électrique ;
- une première couche métallique disposée du côté d'une deuxième face de la puce électronique, opposée à la face d'interconnexion électrique, et solidaire de la deuxième face de la puce électronique ;
- un matériau d'encapsulation disposé autour de la puce électronique, entre la couche de redistribution et la première couche métallique ;
- une deuxième couche métallique comprenant une première face solidarisée par collage direct à la première couche métallique ;
- un substrat disposé contre une deuxième face, opposée à la première face, de la deuxième couche métallique.

Dans ce dispositif, le rôle de dissipateur thermique est rempli par le substrat qui est solidarisé à la puce électronique et au matériau d'encapsulation par l'intermédiaire des première et deuxième couches métalliques qui sont elles-mêmes solidarisées l'une contre l'autre par collage direct. Cette structure ne fait donc pas appel à un matériau d'interface thermique, tel qu'une colle ou une graisse thermique, pour assurer le lien entre l'élément de dissipation thermique et la puce. Cela a pour conséquence d'améliorer fortement la dissipation thermique réalisée au sein du dispositif pour évacuer la chaleur générée par la puce électronique étant donné que la liaison thermique formée par les première et deuxième couches métalliques est bien meilleure que celle obtenue en utilisant un matériau d'interface thermique tel qu'une colle ou une graisse thermique.

Dans un mode de réalisation particulier, les première et deuxième couches métalliques peuvent comporter du cuivre et/ou de l'or.

Dans une variante de réalisation, chacune des première et deuxième couches métalliques peut comporter une couche de cuivre et une couche d'or disposées l'une contre l'autre, les couches d'or pouvant être solidarisées par collage direct l'une contre l'autre. Un avantage de cette variante est que la température de mise en oeuvre du collage direct Au-Au est inférieure à celle d'un collage direct Cu-Cu. Dans cette variante, chacune des première et deuxième couches métalliques peut comporter une couche supplémentaire formant une barrière de diffusion interposée entre la couche de cuivre et la couche d'or, ce qui permet de limiter une potentielle interdiffusion entre les couches de cuivre et d'or et ainsi limiter les risques de création de trous ou de fragilisation de la structure dans le temps. A titre d'exemple, une telle couche d'interdiffusion peut comporter du TiN ou du Ni et avoir une épaisseur comprise entre 5 nm et 50 nm.

Dans tous les cas, les première et deuxième couches métalliques sont réalisées telles que leur rugosité soit assez faible pour permettre un collage direct entre elles, cette faible rugosité pouvant être obtenue soit directement lors de la réalisation des première et deuxième couches métalliques, soit après une planarisation des première et deuxième couches métalliques.

Selon différentes configurations avantageuses, le substrat peut comporter au moins l'un des matériaux suivants : silicium, SiC, Cu, CuMo, CuW, AIN, AISiC, et/ou le substrat peut comporter au moins une chambre de vapeur intégrée, et/ou le substrat peut comporter des structurations favorisant des échanges thermiques avec l'environnement extérieur. Les structurations peuvent par exemple correspondre à des tranchées gravées à travers une partie de l'épaisseur du substrat, et/ou peuvent servir à une circulation de fluide caloporteur.

Les éléments de connexion électrique peuvent être répartis sur une partie de la couche de redistribution dont la surface est plus grande que celle de la face d'interconnexion électrique de la puce électronique.

Le substrat peut être couplé électriquement à la puce électronique, par exemple pour réaliser une prise de masse pour la puce électronique, et/ou le substrat peut comprendre en outre au moins une couche de blindage électromagnétique.

L'invention concerne également un procédé de réalisation d'un dispositif électronique de type SiP, comprenant au moins :
- report d'une puce électronique sur un premier substrat tel qu'une face d'interconnexion électrique de la puce électronique soit disposée du côté du premier substrat ;
- encapsulation de la puce électronique dans un matériau d'encapsulation ;
- réalisation d'au moins une première couche métallique sur le matériau d'encapsulation et la puce électronique ;
- réalisation d'au moins une deuxième couche métallique sur un deuxième substrat ;
- collage direct des première et deuxième couches métalliques l'une contre l'autre ;
- désolidarisation du premier substrat vis-à-vis de la puce électronique et du matériau d'encapsulation ;
- réalisation d'au moins une couche de redistribution couplée électriquement à la face d'interconnexion électrique de la puce électronique ;
- réalisation d'éléments d'interconnexion électrique sur la couche de redistribution tels que les éléments d'interconnexion électrique soient couplés électriquement à la puce électronique par la couche de redistribution.

Ce procédé forme une solution de dissipation thermique intégrée au procédé de packaging et qui ne fait pas appel aux matériaux d'interface thermique.

Le procédé peut être tel que :
- la réalisation de la première couche métallique comporte au moins un dépôt d'une première couche de cuivre sur le matériau d'encapsulation et la puce électronique, et
- la réalisation de la deuxième couche métallique comporte au moins un dépôt d'une deuxième couche de cuivre sur le deuxième substrat.

Dans ce cas, le collage direct des première et deuxième couches métalliques l'une contre l'autre peut correspondre à un collage direct des première et deuxième couches de cuivre l'une contre l'autre.

En variante, le procédé peut être tel que :
- la réalisation de la première couche métallique comporte en outre un dépôt d'une première couche d'or sur la première couche de cuivre, et
- la réalisation de la deuxième couche métallique comporte en outre un dépôt d'une deuxième couche d'or sur la deuxième couche de cuivre, et
- le collage direct des première et deuxième couches métalliques l'une contre l'autre correspond à un collage direct des première et deuxième couches d'or l'une contre l'autre.

De manière optionnelle, une planarisation des première et deuxième couches de cuivre peut être mise en oeuvre avant le dépôt des première et deuxième couches d'or.

En outre, dans cette variante, la réalisation de la première couche de cuivre peut être suivie d'un dépôt d'une première couche de barrière de diffusion sur la première couche de cuivre, la première couche d'or étant ensuite déposée sur la première couche de barrière de diffusion. De même, la réalisation de la deuxième couche de cuivre peut être suivie d'un dépôt d'une deuxième couche de barrière de diffusion sur la deuxième couche de cuivre, la deuxième couche d'or étant ensuite déposée sur la deuxième couche de barrière de diffusion.

Dans une autre variante, le procédé peut être tel que :
- la réalisation de la première couche métallique comporte au moins un dépôt d'une première couche d'or sur le matériau d'encapsulation et la puce électronique, et
- la réalisation de la deuxième couche métallique comporte au moins un dépôt d'une deuxième couche d'or sur le deuxième substrat.

Le procédé peut comporter en outre, entre la réalisation de la deuxième couche métallique et le collage direct des première et deuxième couches métalliques, une planarisation de la première couche métallique et/ou de la deuxième couche métallique. Cette planarisation peut être mise en oeuvre pour atteindre une faible rugosité des couches métalliques si cette faible rugosité n'est pas obtenue directement lors de la réalisation des couches métalliques.

L'encapsulation de la puce électronique peut comporter au moins un dépôt du matériau d'encapsulation sur la puce électronique, puis une planarisation du matériau d'encapsulation.

Plusieurs puces électroniques peuvent être reportées simultanément sur le premier substrat telles qu'une face d'interconnexion électrique de chacune des puces électroniques soit disposée du côté du premier substrat, et les autres étapes du procédé peuvent être mises en oeuvre collectivement pour toutes les puces électroniques, et le procédé peut comporter en outre, après la réalisation des éléments d'interconnexion électrique, une étape de découpe de la structure obtenue de manière à obtenir plusieurs dispositifs électroniques de type SiP distincts comportant chacun une ou plusieurs puces électroniques. Dans ce cas, le packaging collectif réalisé permet de réduire le coût lié à la réalisation de la fonction de dissipation thermique au sein du packaging.

Dans ce cas, lorsque les puces électroniques ont des épaisseurs différentes, la planarisation du matériau d'encapsulation peut être stoppée sur la ou les puces électroniques ayant la plus grande épaisseur. De manière alternative, lorsque les puces électroniques ont des épaisseurs différentes, il est possible que ces puces soient reportées sur le premier substrat telles que les faces supérieures de ces puces (faces opposées à celles se trouvant du côté du premier substrat) soient sensiblement alignées dans un même plan.

Le procédé peut comporter en outre, après la réalisation des éléments d'interconnexion électrique, une gravure du deuxième substrat formant des structurations favorisant des échanges thermiques avec l'environnement extérieur, et/ou le deuxième substrat peut comporter au moins une chambre de vapeur intégrée.

Dans l'ensemble du document, le terme « sur » est utilisé sans distinction de l'orientation dans l'espace de l'élément auquel se rapporte ce terme. Par exemple, dans la caractéristique « sur une face du premier substrat », cette face du premier substrat n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
Les Figures 1 à 8 représentent les étapes d'un procédé de packaging de puces électroniques, objet de la présente invention, selon un mode de réalisation particulier ; et
Les Figures 9 à 11 représentent différentes variantes de réalisation de dispositifs électroniques, objets de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### Exposé détaillé de modes de réalisation particuliers

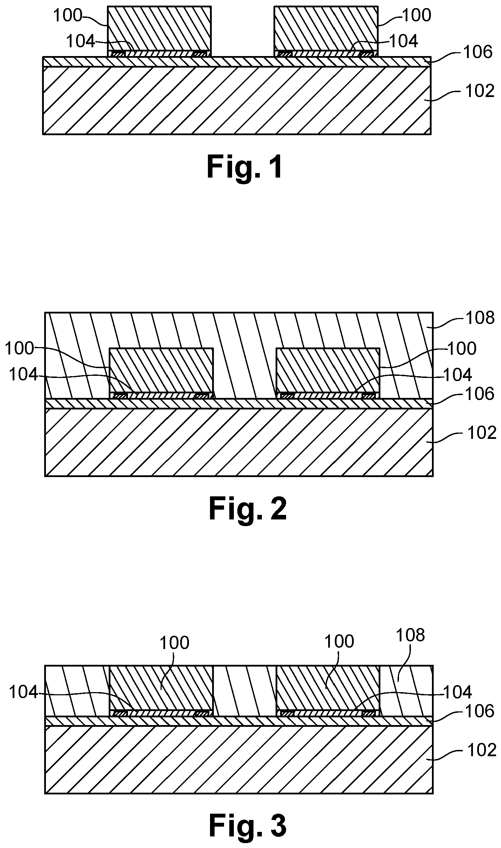

Un procédé de packaging de puces électroniques 100 selon un mode de réalisation particulier est décrit ci-dessous en lien avec les figures 1 à 8.

Les puces électroniques 100 à packager sont tout d'abord reportées sur un premier substrat 102. Chacune des puces 100 comporte une face d'interconnexion électrique disposée du côté du premier substrat 102 et au niveau de laquelle se trouvent par exemple des plots d'interconnexion 104. Le premier substrat 102 comporte par exemple du semi-conducteur, du verre, du métal, ou tout autre matériau adapté.

Sur l'exemple des figures 1 à 8, seules deux puces électroniques 100 sont représentées. Toutefois, le procédé peut être mis en oeuvre collectivement pour un nombre plus important de puces électroniques, ou bien encore pour une seule puce.

Au cours du procédé de packaging, le premier substrat 102 sera destiné à être désolidarisé des puces 100. Afin de faciliter cette désolidarisation, il est possible d'interposer, entre les puces 100 et le premier substrat 102, une couche 106 présentant, à température ambiante, des propriétés adhésives, ces propriétés disparaissant lorsque la couche 106 est chauffée à une température donnée. A titre d'exemple, cette couche 106 peut correspondre à une couche de type « REVALPHA » commercialisée par la société Nitto. En variante, cette couche 106 peut avoir des propriétés adhésives se dégradant sous illumination, par exemple lorsqu'elle est exposée à un rayonnement UV. Dans ce cas, le premier substrat 102 est choisi tel qu'il soit transparent au rayonnement lumineux qui sera utilisé pour dégrader les propriétés adhésives de la couche 106, par exemple à base de verre ou de saphir.

Comme représenté sur la figure 2, les puces 100 sont ensuite encapsulées dans un matériau d'encapsulation 108. Le matériau d'encapsulation 108 est ici déposé en recouvrant les puces 100 ainsi que des parties du substrat 102 (et plus précisément des parties de la couche 106 dans l'exemple décrit ici) adjacentes aux puces 100. Le matériau d'encapsulation 108 comporte par exemple de la résine époxy.

Une planarisation du matériau d'encapsulation 108 avec arrêt sur au moins l'une des puces 100 est ensuite mise en oeuvre (voir figure 3). Dans l'exemple de réalisation décrit ici, étant donné que les puces 100 ont des dimensions similaires, la planarisation est stoppée au niveau de deuxièmes faces, opposées aux faces de connexion électrique, de chacune des puces 100.

Les puces 100 et le matériau d'encapsulation 108 sont ensuite solidarisés à un deuxième substrat 116. Ce deuxième substrat 116 est avantageusement choisi tel qu'il présente une bonne conductivité thermique, par exemple supérieure ou égale à 140 W/m.K, et un faible coefficient d'expansion thermique, par exemple inférieur ou égal à 14 ppm/K. A titre d'exemple, le deuxième substrat 116 peut comporter au moins l'un des matériaux suivants : Si monocristallin ou polycristallin, SiC monocristallin ou polycristallin, Cu, CuMo, CuW, AIN, AlSiC.

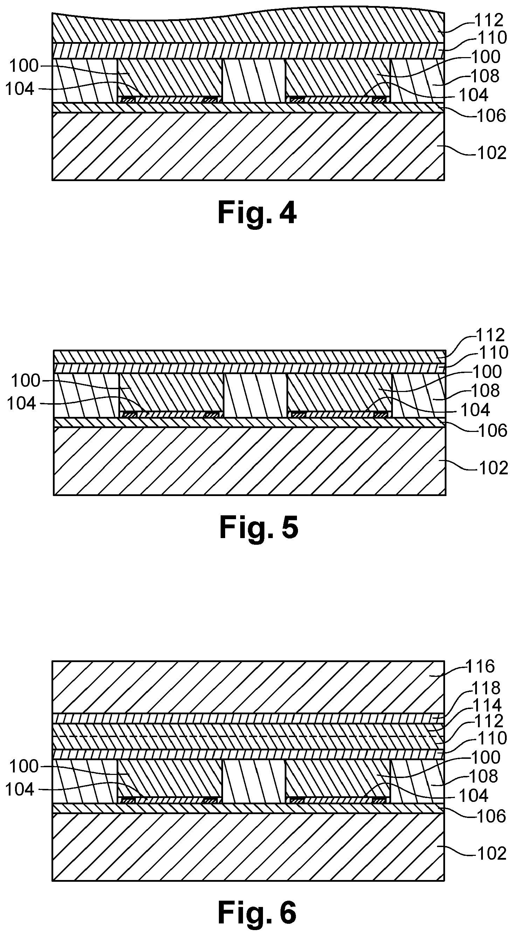

Pour réaliser cette solidarisation, au moins une première couche métallique 112 est réalisée sur le matériau d'encapsulation 108 et les puces 100. Dans le mode de réalisation particulier décrit, une sous-couche métallique, appelée première sous-couche métallique 110, correspondant par exemple à une couche de titane, est formée sur le matériau d'encapsulation 108 et les faces supérieures des puces 100. Du cuivre est ensuite déposé sur la première sous-couche métallique 110 qui sert ici de couche d'accroche pour le cuivre (voir figure 4). Le cuivre est ensuite planarisé pour former la première couche métallique 112 (voir figure 5). Si le cuivre est déposé tel que sa rugosité soit compatible avec la mise en oeuvre d'un collage direct, cette planarisation du cuivre peut ne pas être mise en oeuvre.

Parallèlement à la réalisation de cette première couche métallique 112, au moins une deuxième couche métallique 114 est réalisée sur le deuxième substrat 116. Dans l'exemple de réalisation décrit ici, comme pour la réalisation de la première couche métallique 112, une sous-couche métallique, appelée deuxième sous-couche métallique 118, correspondant par exemple à une couche de titane, est formée sur une face du deuxième substrat 116. Du cuivre est ensuite déposé sur la deuxième sous-couche métallique 118 servant de couche d'accroche pour ce dépôt de cuivre, formant ainsi la deuxième couche métallique 114. Comme pour la première couche métallique 112, une planarisation de ce cuivre peut être mise en oeuvre si la rugosité du cuivre déposé est trop importante et non compatible avec la mise en oeuvre d'un collage direct.

Les première et deuxième couches métalliques 112, 114 ont par exemple une épaisseur comprise entre 50 nm et quelques microns, et avantageusement comprise entre 200 nm et 500 nm.

Le deuxième substrat 116 est ensuite solidarisé au matériau d'encapsulation 108 et aux puces 100 via une solidarisation des première et deuxième couches métalliques 112, 114 l'une contre l'autre. Cette solidarisation des couches métalliques 112, 114 est obtenue en mettant en oeuvre un collage direct de ces couches 112, 114 l'une contre l'autre. Ce collage direct peut être réalisé à température ambiante, ou bien être assisté par une thermocompression. Un collage direct à température ambiante peut être mis en oeuvre lorsque les surfaces de collage des couches 112, 114 ont chacune une rugosité inférieure à 0,5 nm RMS. Un collage direct assisté par thermocompression peut être mis en oeuvre lorsque les surfaces de collage des couches 112, 114 ont chacune une rugosité inférieure à 50 nm RMS. D'aussi faibles rugosités sont par exemple atteignables en soumettant les surfaces de collage à une CMP (planarisation mécano-chimique). En outre, la solidarisation des couches métalliques 112, 114 par collage direct peut être renforcée par la mise en oeuvre, après mise en contact des surfaces de collage l'une contre l'autre, d'un recuit, par exemple à une température comprise entre 200°C et 400°C, et qui permet de renforcer le collage grâce à une interdiffusion métallique engendrée par ce recuit (et une recristallisation lorsque les couches métalliques 112, 114 comportent du cuivre). La structure obtenue à l'issue de cette solidarisation est représentée sur la figure 6. Dans l'exemple de réalisation décrit ci-dessus, les première et deuxième couches métalliques 112, 114 correspondent à des couches de cuivre solidarisées par collage direct l'une contre l'autre.

En variante, il est possible que chacune des première et deuxième couches métalliques 112, 114 corresponde à un empilement d'une couche d'or et d'une couche de cuivre. Dans cette variante, pour chacune des première et deuxième couches métalliques 112, 114, la couche d'or est réalisée après la couche de cuivre de manière à ce que la solidarisation des couches métalliques 112, 114 soit obtenue en réalisant un collage direct des deux couches d'or l'une contre l'autre. Un recuit peut ensuite être mise en oeuvre à plus basse température, par exemple 150 °C. L'épaisseur de chacune des couches d'or est par exemple égale à 50 nm. De manière optionnelle, il est possible que chacune des première et deuxième couches métalliques 112, 114 comporte une couche formant une barrière de diffusion interposée entre la couche de cuivre et la couche d'or. A titre d'exemple, une telle couche barrière de diffusion peut comporter du Ni ou du TiN et avoir une épaisseur comprise entre 5 nm et 50 nm. Dans tous les cas, pour chacune des première et deuxième couches métalliques 112, 114, préalablement au dépôt de la couche d'or et éventuellement avant le dépôt de barrière de diffusion sur la couche de cuivre, il est possible de mettre en oeuvre une planarisation de la couche de cuivre.

Dans une autre variante, les première et deuxième couches métalliques 112, 114 peuvent comporter de l'or, et non du cuivre.

Dans tous les cas, les première et deuxième couches métalliques 112, 114 sont réalisées telles que leur rugosité soit assez faible pour permettre un collage direct entre elles, cette faible rugosité étant obtenue soit à la réalisation des première et deuxième couches métalliques 112, 114, soit après une planarisation des première et deuxième couches métalliques 112, 114.

Le premier substrat 102 est ensuite désolidarisé des puces 100. Dans l'exemple de réalisation décrit ici, cette désolidarisation est obtenue en soumettant la couche 106 à une température ou un rayonnement lumineux (en fonction de la nature de la couche 106) supprimant ou réduisant fortement les propriétés adhésives de cette couche, libérant ainsi le premier substrat 102 du reste de la structure.

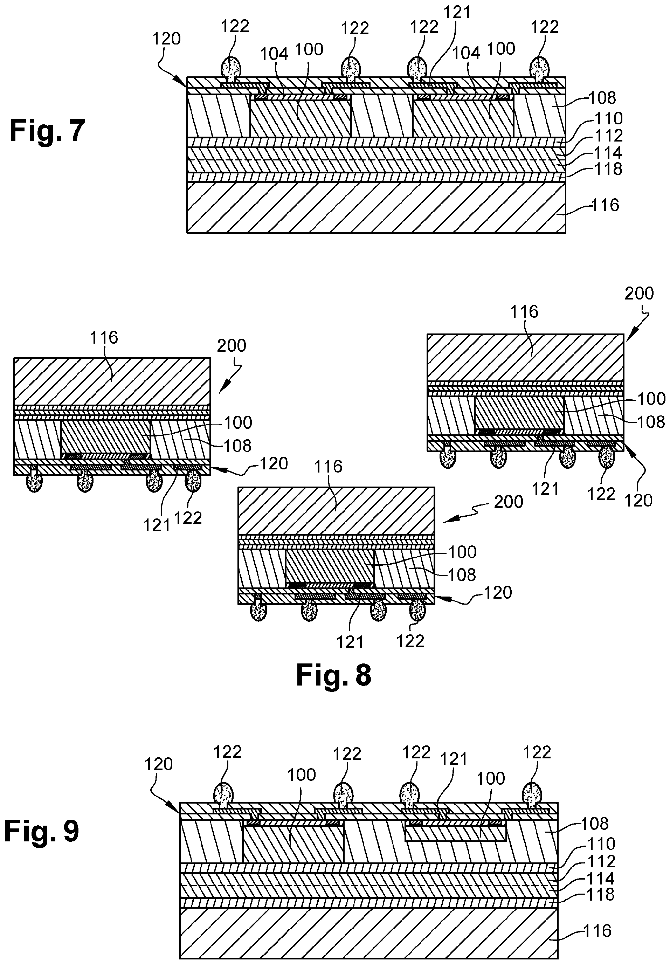

Une ou plusieurs couches de redistribution (RDL) 121, intégrées au sein d'un ou plusieurs niveaux d'interconnexion 120, sont ensuite réalisées contre les faces d'interconnexion des puces 100, puis des éléments d'interconnexion électrique 122, par exemple des microbilles de matériau fusible, sont réalisés sur la ou les couches de redistribution 121 tels que ces éléments d'interconnexion électrique 122 soient couplés électriquement aux plots d'interconnexion 104 des puces 100 par l'intermédiaire de la ou des couches de redistribution 121 (voir figure 7). D'autres éléments d'interconnexion électrique non couplés électriquement aux puces 100 peuvent également être réalisés sur la ou les couches de redistribution 121, ces autres éléments étant destinés à remplir uniquement une fonction de maintien mécanique du packaging qui sera obtenu.

En outre, dans le cas d'un packaging de type FOWLP (comme c'est le cas dans l'exemple décrit ici), les éléments de connexion électrique sont répartis sur une partie de la couche de redistribution dont la surface est plus grande que celle de la face d'interconnexion électrique de la puce électronique, ce qui permet de faciliter la prise de contact de ces éléments

Une opération de découpe de la structure obtenue peut ensuite être mise en oeuvre de manière à singulariser les puces 100 packagées (voir figure 8). Les dispositifs électroniques packagés de type SiP obtenus à l'issue de cette découpe sont désignés chacun par la référence 200.

Sur l'exemple de la figure 8, chaque dispositif SiP 200 comporte une seule puce 100. Toutefois, il est possible que chaque dispositif SiP 200 comporte plusieurs puces 100, selon les fonctions destinées à être remplies par le dispositif SiP 200. Dans ce cas, la redistribution électrique réalisée par la ou les couches de redistribution 121 permet également d'interconnecter les puces 100 d'un même dispositif SiP 200 entre elles.

Dans le mode de réalisation particulier précédemment décrit, les puces 100 reportées sur le premier substrat 102 ont des hauteurs, ou épaisseurs, sensiblement similaires les unes des autres. Ainsi, la planarisation du matériau d'encapsulation 108 est stoppée sur les faces supérieures des différentes puces 100. En variante, il est possible que les puces 100 aient des épaisseurs différentes les unes des autres. Dans ce cas, la planarisation du matériau d'encapsulation 108 est stoppée sur la face supérieure de la ou des puces 100 les plus épaisses. Un exemple de structure obtenue dans une telle variante est représenté sur la figure 9, dans laquelle l'une des deux puces 100 représentées est plus épaisse que l'autre, la planarisation du matériau d'encapsulation 108 ayant été stoppée sur la face supérieure de la puce 100 la plus épaisse. Ainsi après découpe, le dispositif SiP peut comporter des puces 100 ayant des épaisseurs différentes lorsque ces puces 100 font partie d'un même dispositif SiP 200.

De manière alternative, lorsque les puces électroniques 100 d'un même dispositif SiP 200 ont des épaisseurs différentes, il est possible que ces puces 100 soient reportées sur le premier substrat 102 telles que les faces supérieures de ces puces 100 (faces opposées à celles se trouvant du côté du premier substrat 102) soient sensiblement alignées dans un même plan.

Dans le mode de réalisation précédemment décrit, la dissipation thermique est assurée par le deuxième substrat 116 qui n'est pas structuré.

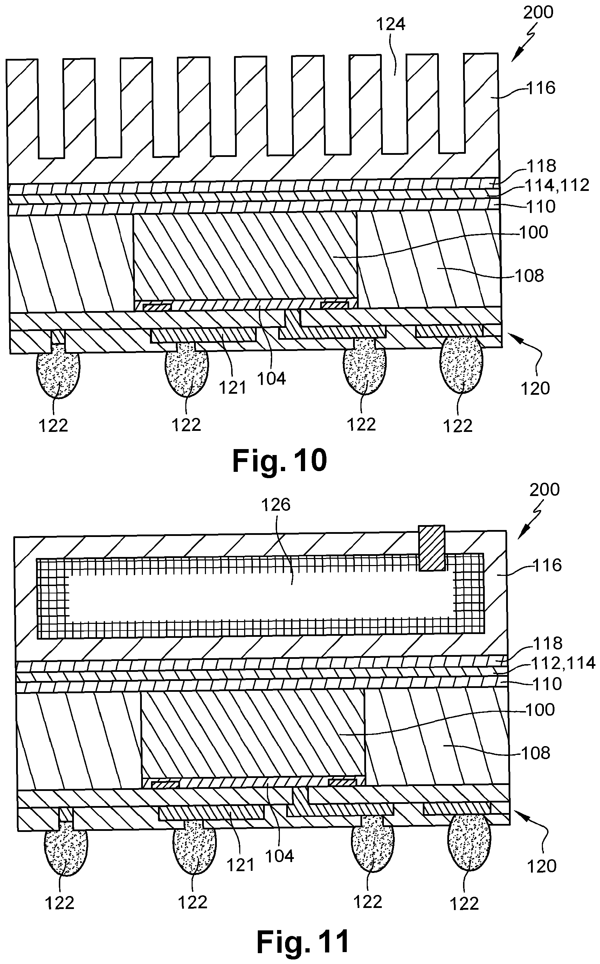

Dans une variante avantageuse, avant la désolidarisation du premier substrat 102, une gravure, par exemple de type ionique réactive (DRIE ou « Deep Reactive Ion Etching » en anglais), du deuxième substrat 116 est mise en oeuvre afin que, à l'issue du procédé, les portions restantes du deuxième substrat 116, entre lesquelles des tranchées 124 ont été gravées, forment une structure de dissipation thermique permettant une plus grande dissipation de chaleur en raison de la plus grande surface d'échange thermique obtenue grâce aux tranchées 124. Un dispositif 200 obtenu dans une telle variante est représenté sur la figure 10.

Dans une autre variante avantageuse, le substrat 116 peut comporter, des chambres de vapeur 126 intégrées (déjà présentes dans le substrat 116 avant sa solidarisation aux puces 100). Le remplissage et le scellement de ces chambres 126 peuvent être réalisés après la solidarisation du substrat 116 aux puces 100. Un dispositif 200 obtenu dans une telle variante est représenté sur la figure 11.

Les variantes précédemment décrites, dans lesquelles le deuxième substrat 116 est utilisé pour former une structure de dissipation thermique ou intègre une chambre de vapeur, peuvent être utilisées lorsque le dispositif 200 comporte plusieurs puces 100. Lorsque ces puces 100 ont des épaisseurs différentes (comme dans l'exemple précédemment décrit en lien avec la figure 9). Il est préférable que la puce libérant le plus de chaleur soit réalisée telle qu'elle corresponde à celle qui ait la plus grande épaisseur afin qu'elle soit au plus près du deuxième substrat 116 pour une meilleure dissipation thermique.

Dans les différentes variantes et exemples précédemment décrits, le deuxième substrat 116 peut être couplé électriquement à la ou aux puces électroniques 100, par exemple pour réaliser une prise de masse pour la ou les puces électroniques 100, et/ou le deuxième substrat 116 peut comprendre en outre au moins une couche de blindage électromagnétique. Par exemple, le deuxième substrat 116 peut former une couche métallique associée à des éléments conducteurs verticaux traversant le matériau d'encapsulation, par exemple sous la forme d'un réseau de piliers à base de cuivre réalisés avant le positionnement des puces 100 ou de blocs positionnés en même temps que les puces 100 et comportant eux-mêmes des éléments de conduction verticaux. Le deuxième substrat 116 peut dans ce cas contacter électriquement ces éléments conducteurs en formant une cage électromagnétique. Il n'est pas nécessaire que le deuxième substrat 116 soit en contact électriquement avec la ou les puces 100.

## Revendications

1. Procédé de réalisation d'un dispositif électronique (200) de type SiP, comprenant au moins :
- report d'une puce électronique (100) sur un premier substrat (102) tel qu'une face d'interconnexion électrique de la puce électronique (100) soit disposée du côté du premier substrat (102) ;
- encapsulation de la puce électronique (100) dans un matériau d'encapsulation (108) ;
- réalisation d'au moins une première couche métallique (112) sur le matériau d'encapsulation (108) et la puce électronique (100) ;
- réalisation d'au moins une deuxième couche métallique (114) sur un deuxième substrat (116) ;
- collage direct des première et deuxième couches métalliques (112, 114) l'une contre l'autre ;
- désolidarisation du premier substrat (102) vis-à-vis de la puce électronique (100) et du matériau d'encapsulation (108) ;
- réalisation d'au moins une couche de redistribution (121) couplée électriquement à la face d'interconnexion électrique de la puce électronique (100) ;
- réalisation d'éléments d'interconnexion électrique (122) sur la couche de redistribution (121) tels que les éléments d'interconnexion électrique (122) soient couplés électriquement à la puce électronique (100) par la couche de redistribution (121).

2. Procédé selon la revendication 1, dans lequel :
- la réalisation de la première couche métallique (112) comporte au moins un dépôt d'une première couche de cuivre sur le matériau d'encapsulation (108) et la puce électronique (100), et
- la réalisation de la deuxième couche métallique (114) comporte au moins un dépôt d'une deuxième couche de cuivre sur le deuxième substrat (116).

3. Procédé selon la revendication 2, dans lequel le collage direct des première et deuxième couches métalliques (112, 114) l'une contre l'autre correspond à un collage direct des première et deuxième couches de cuivre l'une contre l'autre.

4. Procédé selon la revendication 2, dans lequel :
- la réalisation de la première couche métallique (112) comporte en outre un dépôt d'une première couche d'or sur la première couche de cuivre, et
- la réalisation de la deuxième couche métallique (114) comporte en outre un dépôt d'une deuxième couche d'or sur la deuxième couche de cuivre, et
- le collage direct des première et deuxième couches métalliques (112, 114) l'une contre l'autre correspond à un collage direct des première et deuxième couches d'or l'une contre l'autre.

5. Procédé selon l'une des revendications 1 à 4, dans lequel l'encapsulation de la puce électronique (100) comporte au moins un dépôt du matériau d'encapsulation (108) sur la puce électronique (100), puis une planarisation du matériau d'encapsulation (108).

6. Procédé selon l'une des revendications 1 à 5, dans lequel plusieurs puces électroniques (100) sont reportées simultanément sur le premier substrat (102) telles qu'une face d'interconnexion électrique de chacune des puces électroniques (100) soit disposée du côté du premier substrat (102), et dans lequel les autres étapes du procédé sont mises en oeuvre collectivement pour toutes les puces électroniques (100), et comportant en outre, après la réalisation des éléments d'interconnexion électrique (122), une étape de découpe de la structure obtenue de manière à obtenir plusieurs dispositifs électroniques (100) de type SiP distincts comportant chacune une ou plusieurs puces électroniques (100).

7. Procédé selon les revendications 5 et 6, dans lequel, lorsque les puces électroniques (100) ont des épaisseurs différentes, la planarisation du matériau d'encapsulation (108) est stoppée sur la ou les puces électroniques (100) ayant la plus grande épaisseur.

8. Procédé selon l'une des revendications 1 à 7, comportant en outre, après la réalisation des éléments d'interconnexion électrique (122), une gravure du deuxième substrat (116) formant des structurations (124) favorisant des échanges thermiques avec l'environnement extérieur, et/ou dans lequel le deuxième substrat (116) comporte au moins une chambre de vapeur intégrée (126).
